# EUROPEAN PATENT APPLICATION

(11) **EP 4 324 641 A1**
(43) Date of publication of application: **21.02.2024**
(21) Application number: 22788069.7
(22) Date of filing: 30.03.2022
(51) Int. Cl.: B32B 9/00, H01L 41/047, H01L 41/113, H01L 41/193, H01L 41/29, B32B 7/025

(54) **TRANSPARENT CONDUCTIVE PIEZOELECTRIC LAMINATED FILM**

(30) Priority: 15.04.2021 JP 2021069038
(71) Applicant: Kureha Corporation, Chuo-ku Tokyo 103-8552 (JP)
(72) Inventor: IMAJI Makoto, Tokyo 103-8552 (JP)
(74) Representative: Zimmermann & Partner Patentanwälte mbB
(86) International application number: PCT/JP2022/016326
(87) International publication number: WO 2022/220144

(57) **Abstract**

Provided is a transparent conductive piezoelectric laminate film that achieves high transparency and low resistance. The present invention relates to a transparent conductive piezoelectric laminate film including a piezoelectric film, and a conductor layer layered on at least one surface of the piezoelectric film. The transparent conductive piezoelectric laminate film has a diffraction peak in each of a range of 21° ± 2° and a range of 31° ± 2° in X-ray diffraction measurement, and a haze value of 2.0% or less.

## Description

### [TECHNICAL FIELD]

The present invention relates to a transparent conductive piezoelectric laminate film and a device including the same.

### [BACKGROUND ART]

Touch panels are widely used as devices with which information can be input by directly touching an image display unit. A representative type of touch panel is a capacitive touch panel which utilizes a change in current-carrying capacity between a transparent electrode and a finger (Patent Document 1).

A transparent conductive film is used in a position detection sensor utilized in a touch panel. For example, low resistance and high transmittance are achieved by forming an indium tin oxide (ITO) film on a PET film and then increasing the crystallinity of ITO by heat treatment (at or around 150°C).

### [CITATION LIST]

### [Patent Document]

Patent Document 1: JP 05-324203 A

### [SUMMARY OF INVENTION]

### [TECHNICAL PROBLEM]

Recently, technology for simultaneously detecting a position and pressure when an operation surface is touched by a finger or the like has been attracting rising attention, and achieving such technology by combining pressure detection sensors, which are piezoelectric sensors, has been proposed.

However, in a transparent conductive piezoelectric film used in a piezoelectric sensor, such as a PET film, the resistance of the film deteriorates and the color of the film is lost when the film is subjected to heat treatment at a high temperature. Thus, it is difficult to use a transparent conductive piezoelectric film in a touch panel.

The present invention has been made in view of the above problems, and an object of the present invention is to provide a transparent conductive piezoelectric laminate film that achieves high transparency and low resistance.

### [Solution to Problem]

The inventors found that the above problems are solved by a transparent conductive piezoelectric laminate film including a piezoelectric film and a conductor layer layered on at least one surface of the piezoelectric film, the transparent conductive piezoelectric laminate film having specific diffraction peaks and a specific haze value, and arrived at the present invention. Specifically, the present invention relates to the following.

The present invention relates to a transparent conductive piezoelectric laminate film including a piezoelectric film, and a conductor layer laminated on at least one surface of the piezoelectric film, in which the transparent conductive piezoelectric laminate film has a diffraction peak in each of a range of 21° ± 2° and a range of 31° ± 2° in X-ray diffraction measurement, and the transparent conductive piezoelectric laminate film has a haze value of 2.0% or less.

The conductor layer preferably contains indium or an indium compound and a metal other than indium and tin or a compound of that metal.

A diffraction intensity of the diffraction peak in each of the range of 21° ± 2° and the range of 31° ± 2° is preferably 100 cps or more.

The transparent conductive piezoelectric laminate film preferably has a surface resistance of 200 Ω/sq or less as measured from the conductor layer side.

The piezoelectric film preferably contains a fluorine-based resin.

The transparent conductive piezoelectric laminate film preferably further includes a transparent coating layer on a surface of the piezoelectric film, the surface on the conductor layer side.

The present invention also relates to a device including the transparent conductive piezoelectric laminate film.

The present invention also relates to a method of manufacturing the transparent conductive piezoelectric laminate film, the method including:
(A) forming a conductor layer on at least one surface of a transparent piezoelectric film containing a fluorine-based resin to obtain a laminate film; and
(B) annealing the laminate film obtained in the step (A) at 85 to 130°C.

In step (A), it is preferred that, before the conductor layer is formed, a transparent coating layer be formed on a surface of the transparent piezoelectric film, the surface on the side of forming the conductor layer, and the conductor layer be formed on the transparent coating layer.

### [ADVANTAGEOUS EFFECTS OF INVENTION]

According to the present invention, there can be provided a transparent conductive piezoelectric laminate film that achieves high transparency and low resistance.

### [Brief Description of Drawings]

FIG. 1 is a cross-sectional view schematically illustrating an embodiment of a transparent conductive piezoelectric laminate film according to the present invention.
FIG. 2 is a cross-sectional view schematically illustrating another embodiment of a transparent conductive piezoelectric laminate film according to the present invention.
FIG. 3 is a graph showing a result of X-ray diffraction measurement of Example 1.
FIG. 4 is a graph showing a result of X-ray diffraction measurement of Example 2.
FIG. 5 is a graph showing a result of X-ray diffraction measurement of Comparative Example 1.

### [DESCRIPTION OF EMBODIMENTS]

Hereinafter, embodiments of the present invention (hereinafter referred to as "the present embodiment") will be described in detail with reference to the drawings, but the present invention is not limited to these embodiments, and various modifications can be made without departing from the gist of the present invention.

### Transparent Conductive Piezoelectric Laminate Film

A transparent conductive piezoelectric laminate film according to an embodiment of the present invention includes a piezoelectric film, and a conductor layer layered on at least one surface of the piezoelectric film, in which the transparent conductive piezoelectric laminate film has a diffraction peak in each of a range of 21° ± 2° and a range of 31° ± 2° in X-ray diffraction measurement, and the transparent conductive piezoelectric laminate film has a haze value of 2.0% or less.

In the present specification, "laminate" means that each layer is laminated in order and another layer may be laminated between the layers.

### Properties of Transparent Conductive Piezoelectric Laminate Film

The transparent conductive piezoelectric laminate film has a diffraction peak in a range of 21° ± 2° and in a range of 31° ± 2° in X-ray diffraction measurement. Due to this characteristic, a transparent conductive piezoelectric laminate film that achieves high transparency and low resistance can be provided.

In the present specification, the method of the X-ray diffraction measurement is performed by an in-plane method. In the present specification, "has a diffraction peak in a range of 21° ± 2°" means that when a straight line connecting a diffraction intensity (I₁₇) at a diffraction angle (2θ) of 17° and a diffraction intensity (I₂₅) at a diffraction angle (2θ) of 25° is set as a baseline, a mountain-like portion with a diffraction intensity twice or more (preferably three times or more) a baseline diffraction intensity (defined as an average of I₁₇ and I₂₅) is observed in the range of 21 ° ± 2°. Likewise, in the present specification, "has a diffraction peak in a range of 31° ± 2°" means that when a straight line connecting a diffraction intensity (I₂₇) at a diffraction angle (2θ) of 27° and a diffraction intensity (I₃₅) at a diffraction angle (2θ) of 35° is set as a baseline, a mountain-like portion with a diffraction intensity twice or more (preferably three times or more) a baseline diffraction intensity (defined as an average of I₂₇ and I₃₅) is observed in the range of 31° ± 2°.

A method of obtaining the above characteristic is not particularly limited, and an example of the method is forming a conductor layer containing a metal other than indium and tin or a compound of that metal and performing a predetermined annealing treatment.

The diffraction intensity of the diffraction peak in the range of 21° ± 2° is preferably 100 cps or more, more preferably 150 cps or more, and even more preferably 250 cps or more. In addition, the diffraction intensity of the diffraction peak in the range of 31° ± 2° is preferably 100 cps or more. Furthermore, both diffraction intensities are preferably 100 cps or more.

The haze value of the transparent conductive piezoelectric laminate film is 2.0% or less, preferably 1.5% or less, and more preferably 1.0% or less. The lower limit of the haze value is not particularly limited and is, for example, 0.1%. In the present specification, the haze value is measured in accordance with JIS K 7136.

The surface resistance measured from the conductor layer side of the transparent conductive piezoelectric laminate film is preferably 200 Ω/sq or less and more preferably 170 Ω/sq or less. The lower limit of the surface resistance is not particularly limited and is, for example, 5 Ω/sq.

In the present specification, the surface resistance is measured in accordance with JIS K 7194.

The total light transmittance of the transparent conductive piezoelectric laminate film is preferably 80% or more. The upper limit of the total light transmittance is not particularly limited and is, for example, 95%.

In the present specification, the total light transmittance is measured in accordance with JIS K 7361-1.

L* of the transparent conductive piezoelectric laminate film is preferably 80 or more and more preferably 90 or more. The upper limit of L* is not particularly limited.
a* of the transparent conductive piezoelectric laminate film is preferably from - 3 to 3 and more preferably from -2 to 2.
b* of the transparent conductive piezoelectric laminate film is preferably from - 5 to 5.

In the present specification, L*, a*, and b* in the L*a*b* color system are measured in accordance with JIS Z 8722.

The thickness of the transparent conductive piezoelectric laminate film is preferably from 5 to 200 µm and more preferably from 20 to 100 µm. A thickness of 5 µm or greater tends to provide sufficient mechanical strength. In addition, a thickness of 200 µm or less provides sufficient transparency and thus tends to facilitate use in optical applications.

Next, each layer of the transparent conductive laminate film will be described with reference to drawings.

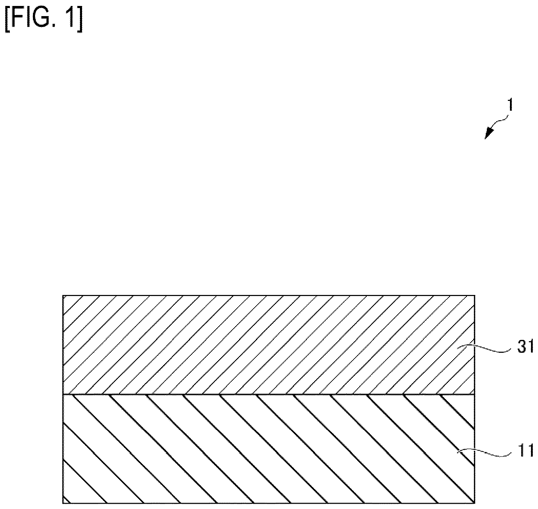

FIG. 1 is a cross-sectional view schematically illustrating an embodiment of the transparent conductive piezoelectric laminate film. In a transparent conductive piezoelectric laminate film 1, a conductor layer 31 is layered on one surface of a piezoelectric film 11.

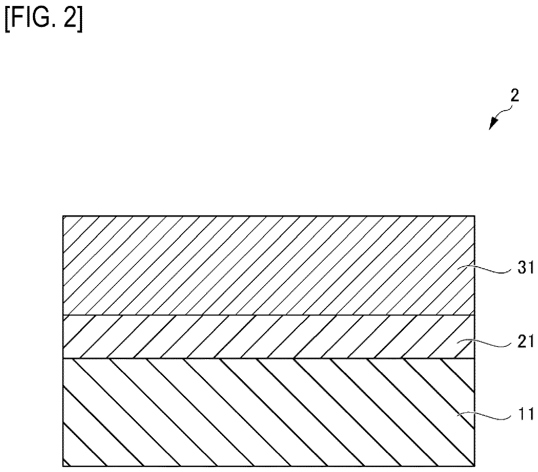

FIG. 2 is a cross-sectional view schematically illustrating another embodiment of the transparent conductive piezoelectric laminate film of the present invention. A transparent conductive piezoelectric laminate film 2 is different from the transparent conductive piezoelectric laminate film 1 in that the transparent conductive piezoelectric laminate film 2 includes a transparent coating layer (first transparent coating layer 21) on a surface of the piezoelectric film 11, the surface of the piezoelectric film 11 on the conductor layer 31 side. Other configurations are the same as those of the transparent conductive piezoelectric laminate film 1.

### Piezoelectric Film

The piezoelectric film 11 is a transparent film (thin film) with piezoelectricity (a property of converting an applied force to a voltage or a property of converting an applied voltage to a force).

Examples of the piezoelectric film 11 include fluorine-based resins; vinylidene cyanide-based polymers; odd-numbered nylons, such as nylon 9 and nylon 11; helical chiral macromolecules, such as polylactic acid; polyhydroxycarboxylic acids, such as polyhydroxybutyrate; cellulose-based derivatives; and polyureas.

Examples of the fluorine-based resin include poly(vinylidene fluoride) (PVDF), vinylidene fluoride-based copolymers (e.g., vinylidene fluoride/trifluoroethylene copolymers, vinylidene fluoride/trifluoroethylene/chlorotrifluoroethylene copolymers, hexafluoropropylene/vinylidene fluoride copolymers, perfluorovinyl ether/vinylidene fluoride copolymers, tetrafluoroethylene/vinylidene fluoride copolymers, hexafluoropropylene oxide/vinylidene fluoride copolymers, hexafluoropropylene oxide/tetrafluoroethylene/vinylidene fluoride copolymers, and hexafluoropropylene/tetrafluoroethylene/vinylidene fluoride copolymers); tetrafluoroethylene-based polymers; and chlorotrifluoroethylene-based polymers. One of these can be used individually, or two or more can be used in combination.

Among these, in terms of high piezoelectricity, weather resistance, heat resistance, and the like to be obtained, a fluorine-based resin is preferred, and poly(vinylidene fluoride) and/or a vinylidene fluoride-based copolymer is more preferred.

The piezoelectric film 11 may further contain a commonly used additive (such as a filler and/or a surfactant).

The thickness of the piezoelectric film 11 is preferably from 5 to 200 µm and more preferably from 20 to 100 µm. A thickness of 5 µm or greater tends to provide sufficient mechanical strength. In addition, a thickness of 200 µm or less provides sufficient transparency and thus tends to facilitate use in optical applications.

### Conductor Layer

The conductor layer 31 is a transparent layer exhibiting conductivity. The conductor layer 31 preferably contains indium or an indium compound and a metal other than indium and tin or a compound of that metal. Such a composition facilitates an increase in the crystallinity of the conductor layer, even by heat treatment at relatively low temperatures, and thus tends to facilitate prevention of performance deterioration of the piezoelectric film and enable high transparency and low resistance to be achieved.

Examples of the indium compound include indium oxides, such as indium tin oxide (ITO), indium oxide, and zinc indium oxide. One of these can be used individually, or two or more can be used in combination. Among these, indium oxide is preferred.

Examples of the metal other than indium and tin include zirconium, scandium, yttrium, tantalum, and hafnium. Examples of the compounds of these metals include metal oxides, such as zirconium oxide, scandium oxide, yttrium oxide, tantalum oxide, and hafnium oxide. One of these can be used individually, or two or more can be used in combination. Among these, tantalum oxide and/or hafnium oxide is preferred.

The conductor layer 31 is preferably free from tin or a tin compound. Such a composition facilitates an increase in the crystallinity of the conductor layer 31, even by heat treatment at relatively low temperatures, and thus tends to facilitate prevention of performance deterioration of the piezoelectric film and enable high transparency and low resistance to be achieved.

The conductor layer 31 may contain a trace component or an inevitable component to the extent that its function is not impaired.

The thickness of the conductor layer 31 is preferably 10 nm or greater, more preferably 15 nm or greater, and even more preferably 20 nm or greater. In addition, the thickness is preferably 55 nm or less and more preferably 40 nm or less. With a thickness of 10 nm or greater, a continuous coating film with good conductivity and a surface resistance value of 1 × 10³ Ω/sq or less tends to be obtained. A thickness of 55 nm or less tends to provide good transparency.

A wiring electrode or the like may be provided on the conductor layer 31. The current flowing through the conductor layer 31 is conducted to a wiring electrode or the like provided on the conductor layer 31.

### Transparent Coating Layer

The transparent conductive piezoelectric laminate film 2 includes a first transparent coating layer 21 on a surface of the piezoelectric film 11, the surface on the conductor layer 31 side of the piezoelectric film 11. That is, the transparent conductive piezoelectric laminate film 2 has a laminate structure in which the piezoelectric film 11, the first transparent coating layer 21, and the conductor layer 31 are layered in this order.

Furthermore, the transparent conductive piezoelectric laminate film 2 can also include a second transparent coating layer on a surface of the piezoelectric film 11, the surface opposite from the conductor layer 31 side of the piezoelectric film 11. In this case, the transparent conductive piezoelectric laminate film has a laminate structure in which the second transparent coating layer, the piezoelectric film 11, the first transparent coating layer 21, and the conductor layer 31 are layered in this order. The thicknesses, structures, and compositions of the first transparent coating layer 21 and the second transparent coating layer may be the same or different. Alternatively, only the second transparent coating layer may be provided.

Examples of the transparent coating layer include a hard coat layer, an optical adjustment layer, and an undercoat layer. The transparent coating layer may be a single layer of these or a plurality of layers in combination. Including the transparent coating layer facilitates prevention of scratches that may occur in the transparent conductive piezoelectric laminate film 2 and facilitates improvement of the transmittance of the transparent conductive piezoelectric laminate film 2. In addition, while an annealing treatment may cause thermal shrinkage of the film and make it difficult to obtain low resistance, including the transparent coating layer prevents thermal shrinkage and facilitates obtaining low resistance.

The transparent coating layer contains, for example, a resin-cured product obtained by curing a resin composition. The resin composition preferably contains at least one selected from thermosetting resin compositions, ultraviolet-curable resin compositions, and electron beam-curable resin compositions. The resin composition may contain at least one selected from (meth)acrylic ester resins, urethane resins, epoxy-based resins, phenoxy-based resins, and melamine-based resins.

The resin composition is, for example, a composition containing a curable compound having an energy beam-reactive group, such as a (meth)acryloyl group or a vinyl group. The wording "(meth)acryloyl group" means including at least one of an acryloyl group or a methacryloyl group. The curable compound preferably contains a polyfunctional monomer or an oligomer containing two or more and preferably three or more energy beam-reactive groups per molecule.

Using an energy beam-curable resin composition enables the resin composition to be cured by irradiation with an energy beam, such as ultraviolet light. Thus, using such a resin composition is preferred also from the viewpoint of the manufacturing process.

The curable compound preferably contains an acrylic monomer. Examples of the acrylic monomer include urethane-modified acrylates and epoxy-modified acrylates.

The resin composition preferably contains an organic fine particle and/or an inorganic fine particle from the viewpoints of increasing strength of the coating film, adjusting the refractive index, increasing the transmittance of the transparent conductive piezoelectric laminate film, and the like. In particular, from the viewpoint of adhesiveness between the transparent coating layer and the conductor layer, the resin composition more preferably contains an inorganic fine particle. Examples of the organic fine particle include organic silicon fine particles, cross-linked acrylic fine particles, and cross-linked polystyrene fine particles. Examples of the inorganic fine particle include synthetic silica particles, talc particles, diatomaceous earth particles, calcium carbonate particles, feldspar particles, quartz particles, aluminum oxide fine particles, zirconium oxide fine particles, titanium oxide fine particles, and iron oxide fine particles.

The average particle size of the fine particle may be 100 nm or less from the viewpoints of being smaller than the thickness of the transparent coating layer and ensuring sufficient transparency. On the other hand, from the viewpoint of producing a colloidal solution, the average particle size may be 5 nm or greater or 10 nm or greater. When an organic fine particle and/or an inorganic fine particle is used, the total amount of the organic fine particle and the inorganic fine particle may be, for example, from 5 to 500 parts by mass or from 20 to 200 parts by mass per 100 parts by mass of the curable compound. In the present specification, the average particle size refers to a volume-based cumulative average particle size (D50) measured by electron microscopy (SEM method).

A transparent coating layer that is too thin may not be able to sufficiently cover fine surface irregularities of the piezoelectric film and may fail to provide a sufficient effect of reducing the haze of the piezoelectric film. In addition, a transparent coating layer that is too thick may cause insufficient piezoelectricity of the transparent conductive piezoelectric laminate film. Thus, from the viewpoint of reducing the haze of the piezoelectric film, the thicknesses of the first transparent coating layer 21 and the thickness of the second transparent coating layer are each preferably 0.20 µm or greater, more preferably 0.35 µm or greater, and even more preferably 0.50 µm or greater. In addition, from the viewpoint of obtaining the transparent conductive piezoelectric laminate film capable of sufficiently exhibiting the piezoelectric characteristics of the piezoelectric film, the thickness of the transparent coating layer is preferably 3.5 µm or less, more preferably 2.5 µm or less, and even more preferably 1.5 µm or less. The transparent coating layer with a thickness in the above ranges can provide both sufficient piezoelectricity and transparency in the transparent conductive piezoelectric laminate film according to the application.

Suitable embodiments of the present invention have been described above, but the present invention is not limited to the embodiments described above. For example, the transparent conductive piezoelectric laminate film 2 described above includes only the first transparent coating layer 21 but may include both the first transparent coating layer 21 and the second transparent coating layer or may include only the second transparent coating layer.

### Applications of Transparent Conductive Piezoelectric Laminate Film

The transparent conductive piezoelectric laminate film according to an embodiment of the present invention is suitably used in a device such as a touch panel of a capacitance type, a resistance film type, or the like.

The device further includes a common display panel unit, such as an LCD, under the transparent conductive piezoelectric laminate film.

The above device is suitably used in display devices of mobile phones, smartphones, personal digital assistants, tablet PCs, notebook personal computers, vending machines, ATMs, FA equipment, OA equipment, medical devices, car navigation systems, and the like.

### Method of Manufacturing Transparent Conductive Piezoelectric Laminate Film

The transparent conductive piezoelectric laminate film according to an embodiment of the present invention can be manufactured by, for example, a method in which a transparent coating layer is formed on at least one surface of a piezoelectric film as necessary, a conductor layer is formed, and an annealing treatment is performed.

### Method of Forming Transparent Coating Layer

The first transparent coating layer can be prepared by applying a solution or dispersion of the above resin composition to one surface of the piezoelectric film, drying the solution or dispersion, and curing the above resin composition. The application in the preparation can be performed by a known method. Examples of the application method include an extrusion nozzle method, a blade method, a knife method, a bar-coating method, a kiss-coating method, a kiss reverse method, a gravure roll method, a dip method, a reverse roll method, a direct roll method, a curtain method, and a squeeze method. The second transparent coating layer can also be prepared on the other surface of the piezoelectric film in the same manner as the first transparent coating layer.

### Method of Forming Conductor Layer

The conductor layer can be formed by a vacuum film forming method, such as a vacuum vapor deposition method, a sputtering method, an ion plating method, or a CVD method. Among these, a sputtering method is preferred since the size of the film formation chamber can be reduced and that a high film formation rate is achieved. Examples of the target that can be used include a metal target and a metal compound target.

Examples of the sputtering gas in the sputtering method include an inert gas, such as Ar. In addition, a reactive gas, such as oxygen gas, can be used in combination as necessary. When a reactive gas is used in combination, the flow rate ratio of the reactive gas is not particularly limited and is, for example, 0.1 flow rate% or more and 5 flow rate% or less relative to a total flow rate ratio of the sputtering gas and the reactive gas.

The atmospheric pressure during sputtering is, for example, 1 Pa or less and preferably 0.7 Pa or less from the viewpoints of preventing a reduction in the sputtering rate, stabilizing discharge, and the like.

The power supply used in the sputtering method may be, for example, any of a DC power supply, an AC power supply, a MF power supply, and an RF power supply, or alternatively may be a combination of these.

The temperature during sputtering is not particularly limited and is preferably 120°C or lower and more preferably 100°C or lower from the viewpoint of heat resistance of the substrate.

### Method of Annealing Treatment (Heat Treatment)

After the conductor layer is formed, an annealing treatment is performed. The temperature in the annealing treatment is preferably from 85 to 130°C and more preferably from 95 to 125°C. A temperature in the above numerical value ranges tends to facilitate prevention of performance deterioration of the piezoelectric film and enable high transparency and low resistance to be achieved.

In particular, the transparent conductive piezoelectric laminate film according to an embodiment of the present invention can be manufactured by a manufacturing method including:
(A) forming a conductor layer on at least one surface of a transparent piezoelectric film containing a fluorine-based resin to obtain a laminate film; and
(B) annealing the laminate film obtained in step (A) at 85 to 130°C.

In step (A), it is preferred that, before the conductor layer is formed, a transparent coating layer be formed on a surface of the transparent piezoelectric film, the surface on the side of forming the conductor layer, and the conductor layer be formed on the transparent coating layer.

### [EXAMPLES]

The present invention will be further described with reference to examples and comparative examples below, but the present invention is not limited to these examples. The properties of the transparent conductive piezoelectric laminate film according to an embodiment of the present invention were measured by the following methods, and the results are shown in Table 1.

### Surface Resistance

The surface resistance of each transparent conductive piezoelectric laminate film was measured from the conductor layer side in accordance with JIS K 7194 using a Loresta GP (available from Mitsubishi Chemical Analytech Co., Ltd.).

### Total Light Transmittance

The total light transmittance of each transparent conductive piezoelectric laminate film was measured in accordance with JIS K 7361-1 using a haze meter ("NDH 7000SP II", available from Nippon Denshoku Industries Co., Ltd.).

### Haze Value

The haze value of each transparent conductive piezoelectric laminate film was measured in accordance with JIS K 7136 using a haze meter ("NDH 7000SP II", available from Nippon Denshoku Industries Co., Ltd.).

### Colorimetry

Each transparent conductive piezoelectric laminate film was measured by a method in accordance with JIS Z 8722 using a spectrocolorimeter ("SE 7700", available from Nippon Denshoku Industries Co., Ltd.).

### Adhesiveness

The adhesiveness of each transparent conductive piezoelectric laminate film was evaluated using a cross-cut method. In the conductor layer of each transparent conductive piezoelectric laminate film, 11 vertical lines and 11 horizontal lines at 1-mm intervals were drawn with a utility knife to prepare 100 squares. Then, a tape (Cellotape (trade name) available from Nichiban Co., Ltd., adhesive strength 4.01 N/10 mm) was applied to the conductor layer and peeled off, and a proportion of the conductor layer that peeled off from the piezoelectric film was evaluated according to the following evaluation criteria based on ASTM D3359.
0B: 65% or more peeled off
1B: 35% or more and less than 65% peeled off
2B: 15% or more and less than 35% peeled off
3B: 5% or more and less than 15% peeled off
4B: less than 5% peeled off
5B: no peeling off

### X-Ray Diffraction Measurement (XRD)

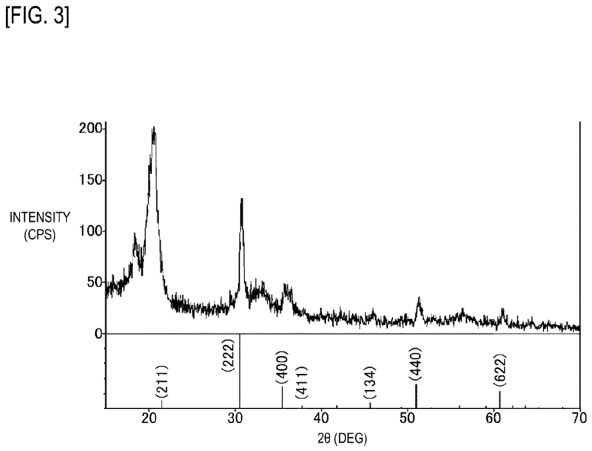

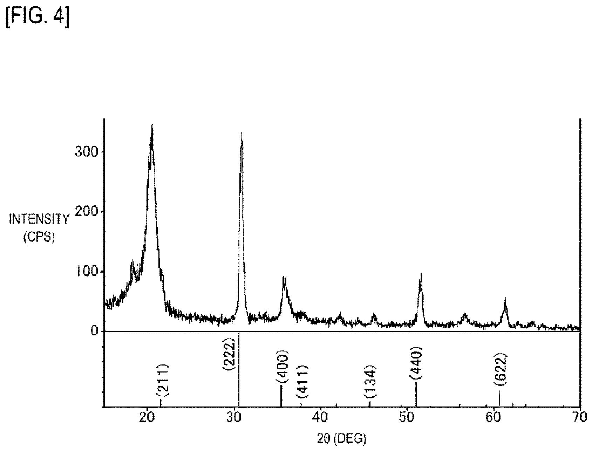

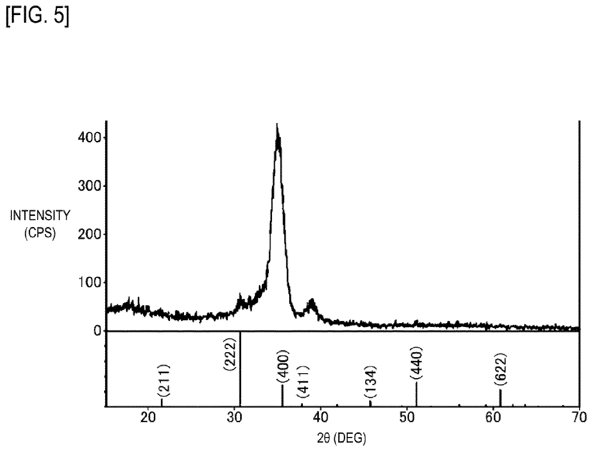

The range of a diffraction angle (2θ) of 15.0 to 70.0° was scanned at a scanning rate of 1°/min using an X-ray diffractometer and measured by an in-plane method. Details of the measurement conditions are described below. The measurement results of Examples 1 and 2 and Comparative Example 1 are shown in FIGS. 3 to 5, respectively. For each of the range of 21° ± 2° and the range of 31° ± 2°, the symbol O indicates that the transparent conductive piezoelectric laminate film had a diffraction peak, and the symbol × indicates that the transparent conductive piezoelectric laminate film had no diffraction peak. In addition, when the transparent conductive piezoelectric laminate film had a diffraction peak, the diffraction intensity (cps) of the diffraction peak is also shown.

### Measurement Conditions

Apparatus: SmartLab, available from Rigaku Corporation
X-ray source: Cu-Kα (λ = 1.5418 Å) 40 kV 30 mA
Detector: SC-70
Step width: 0.04°
Scan range: from 15.0 to 70.0°
Slit: Incident slit = 0.2 mm
   Length limiting slit = 10 mm
   Light receiving slit = 20 mm

### Examples 1 to 4 and Comparative Examples 1 to 3

A resin film (350 mm in width and 120 µm in thickness) molded from poly(vinylidene fluoride) (available from Kureha Corporation) with an inherent viscosity of 1.10 dL/g was uniaxially stretched at a stretching ratio of 4.2 times. After stretching, the film was passed through polarization rolls and subjected to a polarization treatment to obtain a piezoelectric film. At that time, the polarization treatment was performed by applying a DC voltage while the DC voltage was increased from 0 kV to 12.0 kV. The film after the polarization treatment was further heat-treated at 130°C for 1 minute, and a transparent piezoelectric film with a thickness of 40 µm was obtained.

An ultraviolet-curable resin composition containing amorphous silica (average particle size 80 nm) was applied to one surface (first main surface) of the transparent piezoelectric film with a bar coater and dried at 80°C for 2 minutes. The dried coating film was irradiated with UV at an integrated amount of light of 400 mJ/cm² using a UV irradiation device CSOT-40 (available from GS Yuasa Corporation). Furthermore, the same operation was performed on the other surface, and a film having a first transparent coating layer and a second transparent coating layer each with a thickness of 1.0 µm on either surface was obtained.

A conductor layer with a thickness of 40 nm was formed on the first transparent coating layer by a reactive sputtering method using a sintered raw material containing indium oxide, hafnium oxide, and tantalum oxide as a target (Comparative Example 1). This was heat-treated at a predetermined temperature for 180 minutes, and a transparent conductive piezoelectric laminate film (Examples 1 to 4 and Comparative Examples 2 and 3) was obtained. In Comparative Example 3, the film itself deformed. This made it difficult to evaluate and thus the X-ray diffraction measurement could not be performed.

### Example 5

A transparent piezoelectric film with a thickness of 40 µm was obtained in the same manner as in Examples 1 to 4 and Comparative Examples 1 to 3. A conductor layer with a thickness of 40 nm was formed on one surface (first main surface) of the transparent piezoelectric film by a reactive sputtering method using a sintered raw material containing indium oxide, hafnium oxide, and tantalum oxide as a target. This was heat-treated at 100°C for 180 minutes, and a transparent conductive piezoelectric laminate film (Example 5) was obtained.

**[Table 1]**

| | Annealing | | Surface resistance | Total light transmittance | Haze value | L* | a* | b* | Adhesiveness | XRD | |
|---|---|---|---|---|---|---|---|---|---|---|---|
| | Temperature [°C] | Time [min] | [Ω/sq] | % | % | [-] | [-] | [-] | [-] | 21° ± 2° | 31° ± 2° |
| Example 1 | 90 | 180 | 158 | 81.9 | 0.7 | 92.9 | 0.4 | 4.2 | 5B | ○ | ○ |
| | | | | | | | | | | 200 cps | 130 cps |
| Example 2 | 100 | 180 | 103 | 83.2 | 0.5 | 93.4 | 0.5 | 3.6 | 5B | ○ | ○ |
| | | | | | | | | | | 340 cps | 330 cps |
| Example 3 | 110 | 180 | 93 | 83.6 | 0.7 | 93.5 | 0.4 | 3.6 | 5B | ○ | ○ |
| | | | | | | | | | | 460 cps | 305 cps |
| Example 4 | 120 | 180 | 96 | 83.1 | 0.6 | 93.3 | 0.5 | 4.2 | 5B | ○ | ○ |
| | | | | | | | | | | 465 cps | 300 cps |
| Example 5 | 100 | 180 | 105 | 83.3 | 1.8 | 93.9 | 0.4 | 3.6 | 5B | ○ | ○ |
| | | | | | | | | | | 345 cps | 325 cps |
| Comparative Example 1 | - | - | 237 | 81.0 | 0.5 | 92.4 | 0.5 | 4.5 | 5B | × | × |
| Comparative Example 2 | 80 | 180 | 201 | 81.7 | 0.7 | 92.9 | 0.2 | 4.4 | 5B | × | × |
| Comparative Example 3 | 140 | 180 | 1911 | 78.8 | 2.4 | 90.8 | 1.0 | 8.3 | 4B | - | - |

As shown in Table 1, in the examples, the transparent conductive piezoelectric laminate films each exhibited low surface resistance, high total light transmittance, low haze value, and high brightness. Thus, this confirmed that a transparent conductive piezoelectric laminate film that achieves high transparency and low resistance can be obtained by the present invention.

### [Reference Signs List]

1, 2: Transparent conductive piezoelectric laminate film
11: Piezoelectric film
21: First transparent coating layer
31: Conductor layer

## Claims

1. A transparent conductive piezoelectric laminate film comprising:
a piezoelectric film; and
a conductor layer layered on at least one surface of the piezoelectric film, wherein
the transparent conductive piezoelectric laminate film has a diffraction peak in each of a range of 21° ± 2° and a range of 31° ± 2° in X-ray diffraction measurement, and
the transparent conductive piezoelectric laminate film has a haze value of 2.0% or less.

2. The transparent conductive piezoelectric laminate film according to claim 1, wherein the conductor layer comprises indium or an indium compound and a metal other than indium and tin or a compound of that metal.

3. The transparent conductive piezoelectric laminate film according to claim 2, wherein a diffraction intensity of the diffraction peak in each of the range of 21° ± 2° and the range of 31° ± 2° is 100 cps or more.

4. The transparent conductive piezoelectric laminate film according to claim 1, wherein a surface resistance measured from the conductor layer side is 200 Ω/sq or less.

5. The transparent conductive piezoelectric laminate film according to claim 1, wherein the piezoelectric film comprises a fluorine-based resin.

6. The transparent conductive piezoelectric laminate film according to claim 1, further comprising a transparent coating layer on a surface of the piezoelectric film, the surface on the conductor layer side.

7. A device comprising the transparent conductive piezoelectric laminate film described in any one of claims 1 to 6.

8. A method of manufacturing the transparent conductive piezoelectric laminate film described in any one of claims 1 to 6, the method comprising:
(A) forming a conductor layer on at least one surface of a transparent piezoelectric film comprising a fluorine-based resin to obtain a laminate film; and
(B) annealing the laminate film obtained in step (A) at 85 to 130°C.

9. The method of manufacturing the transparent conductive piezoelectric laminate film according to claim 8, wherein in step (A), before the conductor layer is formed, a transparent coating layer is formed on a surface of the transparent piezoelectric film, the surface on the side of forming the conductor layer, and the conductor layer is formed on the transparent coating layer.
